# EUROPÄISCHE PATENTSCHRIFT

(11) **EP 1 025 590 B1**
(45) Veröffentlichungstag und Bekanntmachung des Hinweises auf die Patenterteilung: **17.07.2002**
(21) Anmeldenummer: 98951418.7
(22) Anmeldetag: 16.09.1998
(51) Int. Cl.: H01L 27/02

(54) **ESD-SCHUTZVORRICHTUNG FÜR INTEGRIERTE SCHALTUNGEN**
ELECTROSTATIC DISCHARGE DEVICE FOR INTEGRATED CIRCUITS
DISPOSITIF POUR PROTEGER DES CIRCUITS INTEGRES CONTRE LES DECHARGES ELECTROSTATIQUES

(30) Priorität: 21.10.1997 DE 19746410
(43) Veröffentlichungstag der Anmeldung: 09.08.2000
(73) Patentinhaber: FRAUNHOFER-GESELLSCHAFT ZUR FÖRDERUNG DER ANGEWANDTEN FORSCHUNG E.V., 80636 München (DE); ROBERT BOSCH GmbH, 70469 Stuttgart (DE)
(72) Erfinder: WOLF, Heinrich, D-85716 Unterschleissheim (DE); WILKENING, Wolfgang, D-72793 Pfullingen (DE)
(74) Vertreter: Schoppe, Fritz, Dipl.-Ing.
(86) Internationale Anmeldenummer: EP9805896
(87) Internationale Veröffentlichungsnummer: WO9921229

(56) Entgegenhaltungen:
- WO-A-95/17011
- GB-A- 2 288 064
- US-A- 5 276 350
- US-A- 5 471 082
- US-A- 5 607 867
- PATENT ABSTRACTS OF JAPAN vol. 005, no. 109 (E-065), 15. Juli 1981 -& JP 56 048167 A (NEC CORP), 1. Mai 1981
- PATENT ABSTRACTS OF JAPAN vol. 095, no. 004, 31. Mai 1995 & JP 07 029820 A (YOKOGAWA ELECTRIC CORP), 31. Januar 1995

## Beschreibung

Die vorliegende Erfindung bezieht sich auf Schutzvorrichtungen für elektronische Vorrichtungen gegen elektrostatische Entladungen, sogenannte ESD-Schutzvorrichtungen, und insbesondere auf solche ESD-Schutzvorrichtungen für integrierte Schaltungen (ICs; IC = Integrated Circuit).

Um einen ESD-Schutz für integrierte Schaltungen zu schaffen, ist es beispielsweise bekannt, Transistoren zu verwenden, deren Drain-Elektrode und Gate-Elektrode mittels Zenerdioden aktiv geklammert sind. Derartige bekannte ESD-Schutzvorrichtungen weisen jedoch einen sehr großen Flächenbedarf auf und sind daher kostenintensiv.

Die DE 693 11 001 T2 offenbart eine Diodenstruktur zum Schutz von IC-Anschlüssen, die zwei Dioden aufweist, wobei eine der Dioden zwischen ein Massepotential und die Verbindung zwischen einer Anschlußfläche der IC und der zu schützenden IC geschaltet ist. Die zweite Diode ist zwischen ein Versorgungsspannungspotential und die oben genannte Verbindung geschaltet. Die beiden Dioden sind jeweils in unterschiedlicher Polung verschaltet, so daß die erste Diode für negative Spannungen in Flußrichtung gepolt ist, während die zweite Diode für positive Spannungen in Flußrichtung gepolt ist. Bei den Dioden handelt es sich jeweils um übliche PN-Dioden mit einem schwach dotierten PN-Übergang, wobei die Anschlußgebiete der PN-Dioden stark dotiert sind.

Die US 5 521 783 bezieht sich auf eine zweistufige Schaltung zum Schutz vor elektrostatischen Entladungen, wobei die erste Stufe durch einen Transistor mit einer hohen Durchbruchspannung gebildet ist, während die zweite Stufe durch einen Transistor mit einer geringen Durchbruchspannung gebildet ist.

Die Aufgabe der vorliegenden Erfindung besteht darin, eine ESD-Schutzvorrichtung für integrierte Schaltungen mit einem verringerten Platzbedarf und somit einem geringeren Kostenaufwand zu schaffen.

Diese Aufgabe wird durch eine ESD-Schutzvorrichtung für integrierte Schaltungen gemäß dem Anspruch 1 gelöst.

Die vorliegende Erfindung schafft eine ESD-Schutzvorrichtung für eine integrierte Schaltung, die in das Halbleitersubstrat der integrierten Schaltung integriert ist. Die Schutzvorrichtung umfaßt einen hoch dotierten Bereich einer ersten Dotierungsart, der mit einer ersten Anschlußelektrode versehen ist, sowie einen hoch dotierten Bereich einer zweiten Dotierungsart, der mit einer zweiten Anschlußelektrode versehen ist. Ein schwach dotierter Bereich der ersten Dotierungsart grenzt an den hoch dotierten Bereich der ersten Dotierungsart an, während ein schwach dotierter Bereich der zweiten Dotierungsart an den hoch dotierten Bereich der zweiten Dotierungsart und den schwach dotierten Bereich der ersten Dotierungsart angrenzt, derart, daß die schwach dotierten Bereiche zumindest zwischen den hoch dotierten Bereichen angeordnet sind. Der durch den schwach dotierten Bereich der zweiten Dotierungsart festgelegte Abstand zwischen dem schwach dotierten Bereich der ersten Dotierungsart und dem hoch dotierten Bereich der zweiten Dotierungsart ist nun derart dimensioniert, daß die mit zunehmender an den Anschlußelektroden anliegender Sperrspannung wachsende Verarmungszone im schwach dotierten Bereich der zweiten Dotierungsart den stark dotierten Bereich der zweiten Dotierungsart erreicht, bevor die Durchbruchspannung zwischen dem schwach dotierten Bereich der zweiten Dotierungsart und dem schwach dotierten Bereich der ersten Dotierungsart erreicht wird.

Es ist gemäß der vorliegenden Erfindung dabei unerheblich, ob die erste Dotierungsart eine p-Dotierung ist und die zweite Dotierungsart eine n-Dotierung ist oder umgekehrt.

Bei einem Ausführungsbeispiel der vorliegenden Erfindung ist in dem schwach dotierten Bereich der ersten Dotierungsart zwischen dem schwach dotierten Bereich der zweiten Dotierungsart und dem stark dotierten Bereich der ersten Dotierungsart ein stark dotierter Bereich der zweiten Dotierungsart vorgesehen, der über die zweite Anschlußelektrode mit dem stark dotierten Bereich der ersten Dotierungsart verbunden ist. Der schwach dotierte Bereich der ersten Dotierungsart ist vorzugsweise als eine Wanne um den stark dotierten Bereich der ersten Dotierungsart ausgebildet, wobei der schwach dotierte Bereich der zweiten Dotierungsart die Wanne umgibt. Der schwach dotierte Bereich der zweiten Dotierungsart kann von einer vergrabenen, hoch dotierten Schicht der zweiten Dotierungsart umgeben sein.

Die vorliegende Erfindung schafft eine Vorrichtung zum Schutz von integrierten Schaltungen gegenüber elektrostatischen Entladungen (ESD) auf einer integrierten Schaltung. Durch die Integration der ESD-Schutzvorrichtung in dem Halbleitersubstrat der integrierten Schaltung ist ein flächensparender ESD-Schutz möglich, insbesondere an Anschlußstellen mit hohen Betriebsspannungen von beispielsweise mehr als 35 Volt in Mischprozessen. Somit schafft die vorliegende Erfindung eine erhebliche Kostenreduktion bei integrierten Schaltungen, wie sie beispielsweise bei Automobilanwendungen verwendet werden.

Bevorzugte Ausführungsbeispiele der vorliegenden Erfindung werden nachfolgend bezugnehmend auf die beiliegenden Zeichnungen näher erläutert. Es zeigen:
- Fig. 1: eine schematische Querschnittansicht eines ersten Ausführungsbeispiels einer ESD-Schutzvorrichtung gemäß der vorliegenden Erfindung;
- Fig. 2: eine schematische Querschnittansicht eines zweiten Ausführungsbeispiels einer ESD-Schutzvorrichtung gemäß der vorliegenden Erfindung; und
- Fig. 3: eine schematische Darstellung, die den Einsatz der erfindungsgemäßen ESD-Schutzvorrichtung zeigt.

Die nachfolgend bezugnehmend auf die Zeichnungen durchgeführte Erläuterung der vorliegenden Erfindung erfolgt jeweils hinsichtlich der dargestellten Dotierungsarten, wobei es jedoch offensichtlich ist, daß die jeweiligen Dotierungen umgekehrt sein können, wobei dann jeweils auch die Spannungen umgekehrt sind.

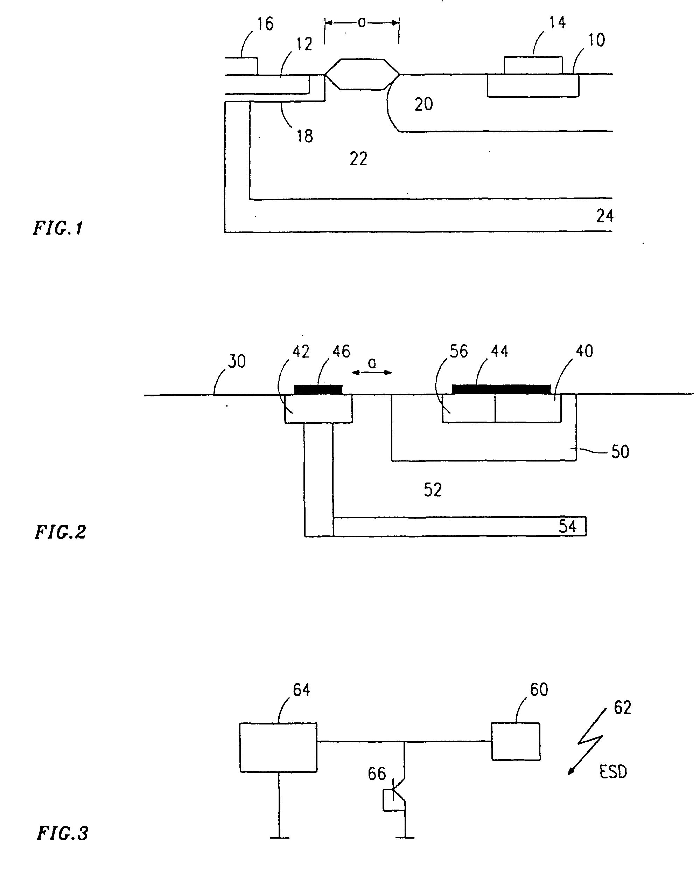

In Fig. 1 ist ein erstes Ausführungsbeispiel einer lateral einstellbaren Durchbruchstruktur zum ESD-Schutz von integrierten Schaltungen (ICs) dargestellt. In einem Halbleitersubstrat sind ein stark dotiertes p⁺-Gebiet 10 und ein stark dotiertes n⁺-Gebiet 12 vorgesehen. Auf das stark dotierte p⁺-Gebiet 10 ist eine Elektrode 14 aufgebracht, die als Anode bezeichnet werden kann, während auf das stark dotierte n⁺-Gebiet 12 eine Elektrode 16 aufgebracht ist, die als Kathode bezeichnet werden kann. Wie in Fig. 1 gezeigt ist, ist bei dem dargestellten Ausführungsbeispiel das stark dotierte Gebiet 12 von einem ebenfalls stark dotierten n-Gebiet 18 umgeben. Das stark dotierte p⁺-Gebiet 10 ist von einer schwach dotierten p-Wanne 20 umgeben. Die p-Wanne 20 ist wiederum von einem schwach dotierten n-Gebiet 22 umgeben, derart, daß zwischen der p-Wanne 20 und dem stark dotierten n-Gebiet 18 ein schwach dotiertes n-Gebiet liegt. Diese beschriebene laterale Abfolge von unterschiedlich dotierten Halbleitergebieten ist in Fig. 1 dargestellt. Die Dotierung des schwach dotierten p-Gebiets kann in einem Bereich von typischerweise 10¹⁷/cm³ liegen, während die Dotierung des schwach dotierten n-Gebiets 22 typischerweise in einem Bereich von 10¹⁵/cm³ liegt. Die Dotierung des stark dotierten n-Gebiets 18 liegt in einem Bereich von typischerweise 10¹⁹/cm³.

Für den Einsatz einer derartigen Vorrichtung als ESD-Schutz ist die Sperrpolung des PN-Übergangs zwischen dem schwach dotierten p-Gebiet 20 und dem schwach dotierten n-Gebiet 22 relevant. Gemäß der vorliegenden Erfindung wird der Abstand zwischen dem schwach dotierten p-Gebiet 20 und dem stark dotierten n-Gebiet 18, der in Fig. 1 mit a bezeichnet ist, derart dimensioniert, daß die mit zunehmender Sperrspannung wachsende Verarmungszone im schwach dotierten n-Gebiet 22 das stark dotierte n-Gebiet 18 erreicht, bevor die prozeßbedingte Durchbruchspannung zwischen dem schwach dotierten p-Gebiet 20 und dem schwach dotierten n-Gebiet 22 erreicht wird. Somit erfolgt bei der erfindungsgemäßen Struktur der Durchbruch zwischen den Gebieten 20 und 18 bei geringeren Spannungen als der prozeßbedingte Durchbruch zwischen den Gebieten 20 und 22.

Die Durchbruchspannung für den Durchbruch zwischen dem schwach dotierten p-Gebiet 20 und dem stark dotierten n-Gebiet 18 der obigen Struktur, der einen Lawinendurchbruch darstellt, ist im Layout über den Parameter a, d.h. den genannten Abstand, auf Spannungen unterhalb der Spannungsfestigkeit des Prozesses einstellbar. Somit ist diese Struktur grundsätzlich als ESD-Schutz geeignet.

Wie in Fig. 1 dargestellt ist, ist das schwach dotierte n-Gebiet 22 vorzugsweise von einer vergrabenen stark dotierten n⁺-Schicht 24 umgeben, die mit dem stark dotierten n-Bereich 18 verbunden ist. Es sei darauf hingewiesen, daß das stark dotierte n-Gebiet 18 in Fig. 1 optional ist. Wenn das stark dotierte n-Gebiet 18 nicht vorliegt, kann die Durchbruchspannung durch das Einstellen des Abstands zwischen dem stark dotierten n⁺-Gebiet 12 und dem schwach dotierten p-Gebiet 20 eingestellt werden.

In Fig. 2 ist eine Querschnittansicht eines weiteren Ausführungsbeispiels der vorliegenden Erfindung dargestellt. Wiederum ist in einem Halbleitersubstrat 30 ein stark dotiertes p⁺-Gebiet 40 und ein stark dotiertes n⁺-Gebiet 42 vorgesehen. Auf diese Gebiete sind jeweils wieder Elektroden 44 bzw. 46 aufgebracht. Das stark dotierte p⁺-Gebiet 40 ist von einer schwach dotierten p-Wanne 50 umgeben. Diese Wanne 50 ist wiederum von einem schwach dotierten n-Gebiet 52 umgeben, das wiederum durch eine vergrabene stark dotierte n⁺-Schicht 54 umgeben ist. Im Gegensatz zu dem in Fig. 1 dargestellten Ausführungsbeispiel ist nun jedoch in der p-Wanne ferner ein stark dotiertes n⁺-Gebiet 56 vorgesehen, wobei dieses stark dotierte n⁺-Gebiet 56 über die Elektrode 44 mit dem stark dotierten p⁺-Gebiet 40 verbunden ist. Die in Fig. 2 dargestellte Struktur kann als ein Transistor aufgefaßt werden, dessen Kollektorelektrode durch die Elektrode 46 gebildet ist, während dessen Emitterelektrode und Basiselektrode kurzgeschlossen sind und durch die Elektrode 44 realisiert sind.

Bei dem in Fig. 2 dargestellten Ausführungsbeispiel kann durch den einstellbaren kollektorseitigen Durchbruch, wobei die Durchbruchspannung wiederum durch das Einstellen des Abstands a einstellbar ist, die Wanne aufgeladen werden, wobei der vertikale Transistor zünden kann. Somit wird ein sehr niederohmiges Verhalten und eine hohe ESD-Festigkeit erreicht.

Fig. 3 zeigt ein Blockdiagramm zur Veranschaulichung, wie die erfindungsgemäße ESD-Schutzvorrichtung eingesetzt werden kann. Bei 60 ist eine Eingangs/Ausgangs-Anschlußfläche einer integrierten Schaltung dargestellt, die möglicherweise einer elektrostatischen Entladung 62 ausgesetzt sein kann. Die Eingangs/Ausgangs-Anschlußfläche ist mit einer integrierten Schaltung 64, die geschützt werden soll, verbunden. Wie in Fig. 3 dargestellt ist, ist zwischen der Anschlußfläche 60 und der Schaltung 64 das ESD-Schutzelement 66 gemäß der vorliegenden Erfindung auf Masse geschaltet, um somit die auftretende Spannung zu begrenzen.

## Patentansprüche

1. ESD-Schutzvorrichtung (66) für eine integrierte Schaltung (64), die in ein Halbleitersubstrat der integrierten Schaltung integriert ist, mit folgenden Merkmalen:
einem hoch dotierten Bereich (10; 40) eines ersten Dotierungstyps, der mit einer ersten Anschlußelektrode (14; 44) versehen ist;
einem hoch dotierten Bereich (12, 18; 42) eines zweiten Dotierungstyps, der mit einer zweiten Anschlußelektrode (16; 46) versehen ist;
einem schwach dotierten Bereich (20; 50) des ersten Dotierungstyps, der an den hoch dotierten Bereich (10; 40) des ersten Dotierungstyps angrenzt; und
einem schwach dotierten Bereich (22; 52) des zweiten Dotierungstyps, der an den hoch dotierten Bereich (12, 18; 42) des zweiten Dotierungstyps und den schwach dotierten Bereich (20; 50) des ersten Dotierungstyps angrenzt, derart, daß die schwach dotierten Bereiche zwischen den hoch dotierten Bereichen angeordnet sind,
**dadurch gekennzeichnet, daß** der durch den schwach dotierten Bereich (22; 52) des zweiten Dotierungstyps festgelegte Abstand zwischen dem schwach dotierten Bereich (20; 50) des ersten Dotierungstyps und dem hoch dotierten Bereich (12, 18; 42) des zweiten Dotierungstyps derart eingestellt ist, daß die mit zunehmender an den Anschlußelektroden (14, 16; 44, 46) anliegender Sperrspannung wachsende Verarmungszone im schwach dotierten Bereich (22; 52) des zweiten Dotierungstyps den stark dotierten Bereich (12, 18; 42) des zweiten Dotierungstyps erreicht, bevor die Durchbruchspannung zwischen dem schwach dotierten Bereich (22; 52) des zweiten Dotierungstyps und dem schwach dotierten Bereich des ersten Dotierungstyps erreicht wird.

2. ESD-Schutzvorrichtung nach Anspruch 1, bei der in dem schwach dotierten Bereich (50) des ersten Dotierungstyps zwischen dem schwach dotierten Bereich (52) des zweiten Dotierungstyps und dem stark dotierten Bereich (40) des ersten Dotierungstyps ein stark dotierter Bereich des zweiten Dotierungstyps vorgesehen ist, der über die zweite Anschlußelektrode (44) mit dem stark dotierten Bereich des ersten Dotierungstyps verbunden ist.

3. ESD-Schutzvorrichtung nach Anspruch 1 oder Anspruch 2, bei der der schwach dotierte Bereich (20; 50) des ersten Dotierungstyps als Wanne des ersten Dotierungstyps um den stark dotierten Bereich (10; 40) des ersten Dotierungstyps ausgebildet ist, wobei der schwach dotierte Bereich (22; 52) des zweiten Dotierungstyps die Wanne des ersten Dotierungstyps umgibt.

4. ESD-Schutzvorrichtung nach Anspruch 3, bei der der schwach dotierte Bereich (22; 52) des zweiten Dotierungstyps von einer vergrabenen stark dotierten Schicht des zweiten Dotierungstyps umgeben ist.

5. ESD-Schutzvorrichtung nach einem der Ansprüche 1 bis 4, bei der der erste Dotierungstyp eine p-Dotierung ist und der zweite Dotierungstyp eine n-Dotierung ist.

6. ESD-Schutzvorrichtung nach einem der Ansprüche 1 bis 4, bei der der erste Dotierungstyp eine n-Dotierung ist und der zweite Dotierungstyp eine p-Dotierung ist.

## Claims

1. An ESD protection device (66) for an integrated circuit (64) which is integrated in a semiconductor substrate of said integrated circuit, comprising:
a heavily doped region (10; 40) of a first doping type provided with a first connection electrode (14; 44);
a heavily doped region (12, 18; 42) of a second doping type provided with a second connection electrode (16; 46);
a lightly doped region (20; 50) of the first doping type bordering on said heavily doped region (10; 40) of the first doping type; and
a lightly doped region (22; 52) of the second doping type bordering on said heavily doped region (12, 18; 42) of the second doping type and said lightly doped region (20; 50) of the first doping type in such a way that the lightly doped regions are arranged between said heavily doped regions,
**characterized in that** the distance which exists between the lightly doped region (20; 50) of the first doping type and the heavily doped region (12, 18; 42) of the second doping type and which is determined by the lightly doped region (22; 52) of the second doping type is adjusted in such a way that the depletion zone in the lightly doped region (22; 52) of the second doping type, which becomes larger as the blocking voltage applied to the connection electrodes (14, 16; 44, 46) increases, reaches the heavily doped region (12, 18; 42) of the second doping type before the breakthrough voltage between the lightly doped region (22; 52) of the second doping type and the lightly doped region of the first doping type has been reached.

2. An ESD protection device according to claim 1, wherein a heavily doped region of the second doping type is provided in the lightly doped region (50) of the first doping type between the lightly doped region (52) of the second doping type and the heavily doped region (40) of the first doping type, said heavily doped region of the second doping type being connected to the heavily doped region of the first doping type via the second connection electrode (44).

3. An ESD protection device according to claim 1 or claim 2, wherein the lightly doped region (20; 50) of the first doping type is implemented as a well of the first doping type around the heavily doped region (10; 40) of the first doping type, the lightly doped region (22; 52) of the second doping type surrounding said well of the first doping type.

4. An ESD protection device according to claim 3, wherein the lightly doped region (22; 52) of the second doping type is surrounded by a buried heavily doped layer of the second doping type.

5. An ESD protection device according to one of claims 1 to 4, wherein the first doping type is p doping and the second doping type is n doping.

6. An ESD protection device according to one of claims 1 to 4, wherein the first doping type is n doping and the second doping type is p doping.

## Revendications

1. Dispositif de protection ESD (66) pour un circuit intégré (64), intégré dans un substrat à semi-conducteur du circuit intégré, aux caractéristiques suivantes :
une zone hautement dopée (10 ; 40) d'un premier type de dopage, pourvue d'une première électrode de raccordement (14 ; 44) ;
une zone hautement dopée (12, 18 ; 42) d'un second type de dopage, pourvue d'une seconde électrode de raccordement (16 ; 46) ;
une zone faiblement dopée (20 ; 50) du premier type de dopage, adjacente à la zone hautement dopée (10 ; 40) du premier type de dopage ; et
une zone faiblement dopée (22 ; 52) du second type de dopage, adjacente à la zone hautement dopée (12, 18 ; 42) du second type de dopage et à la zone faiblement dopée (20 ; 50) du premier type de dopage, de sorte que les zones faiblement dopées soient disposées entre les zones hautement dopées,
**caractérisé par le fait que** la distance, fixée par la zone faiblement dopée (22 ; 52) du second type de dopage, entre la zone faiblement dopée (20 ; 50) du premier type de dopage et la zone hautement dopée (12, 18 ; 42) du second type de dopage est réglée de telle sorte que la zone d'appauvrissement, croissant au fur et à mesure qu'augmente la tension de blocage présente aux électrodes de raccordement (14, 16 ; 44, 46), dans la zone faiblement dopée (22 ; 52) du second type de dopage atteigne la zone fortement dopée (12, 18 ; 42) du second type de dopage avant que ne soit atteinte la tension de rupture entre la zone faiblement dopée (22 ; 52) du second type de dopage et la zone faiblement dopée du premier type de dopage.

2. Dispositif de protection ESD selon la revendication 1, dans lequel il est prévu, dans la zone faiblement dopée (50) du premier type de dopage, entre la zone faiblement dopée (52) du second type de dopage et la zone fortement dopée (40) du premier type de dopage, une zone fortement dopée du second type de dopage qui est reliée, par l'intermédiaire de la seconde électrode de raccordement (44), à la zone fortement dopée du premier type de dopage.

3. Dispositif de protection ESD selon la revendication 1 ou la revendication 2, dans lequel la zone faiblement dopée (20 ; 50) du premier type de dopage est réalisée sous forme de cuve du premier type de dopage autour de la zone fortement dopée (10 ; 40) du premier type de dopage, la zone faiblement dopée (22 ; 52) du second type de dopage entourant la cuve du premier type de dopage.

4. Dispositif de protection ESD selon la revendication 3, dans lequel la zone faiblement dopée (22 ; 52) du second type de dopage est entourée par une couche enterrée fortement dopée du second type de dopage.

5. Dispositif de protection ESD selon l'une des revendications 1 à 4, dans lequel le premier type de dopage est un dopage p et le second type de dopage est un dopage n.

6. Dispositif de protection ESD selon l'une des revendications 1 à 4, dans lequel le premier type de dopage est un dopage n et le second type de dopage est un dopage p.
